# EUROPÄISCHE PATENTSCHRIFT

(11) **EP 4 573 378 B1**
(45) Veröffentlichungstag und Bekanntmachung des Hinweises auf die Patenterteilung: **10.12.2025**
(21) Anmeldenummer: 24702345.0
(22) Anmeldetag: 26.01.2024
(51) Int. Cl.: G01R 33/3875

(54) **NMR-APPARATUR MIT EFFIZIENTER STROMQUELLE**
NMR APPARATUS WITH EFFICIENT CURRENT SOURCE
APPAREIL RMN AVEC SOURCE DE COURANT EFFICACE

(30) Priorität: 20.02.2023 DE 102023201434
(43) Veröffentlichungstag der Anmeldung: 25.06.2025
(73) Patentinhaber: Bruker Switzerland AG, 8117 Fällanden (CH)
(72) Erfinder: SCHENKEL, Michael, 8344 Bäretswil (CH); HEGNAUER, Stefan, 8634 Hombrechtikon (CH); ZELLWEGER, Martin, 8500 Frauenfeld (CH)
(74) Vertreter: Kohler Schmid Möbus Patentanwälte
(86) Internationale Anmeldenummer: PCT/EP2024/051964
(87) Internationale Veröffentlichungsnummer: WO 2024/175306

(56) Entgegenhaltungen:
- US-B2- 6 492 817
- ANONYMOUS: "Configuration For Boss2, 3 And Wb; System Architecture/Overview; Figure 9.2: Block Diagram Of The Scb20 Shim Current Board - Bruker NMR BSMS System User Manual [Page 73] | ManualsLib", BSMS SYSTEM FOR AVANCE NEO USER MANUAL VERSION 001, 14 January 2019 (2019-01-14), pages 1 - 234, XP093146264, Retrieved from the Internet <URL:https://www.manualslib.com/manual/2328796/Bruker-Nmr-Bsms-System.html?page=73#manual> [retrieved on 20240327]

## Beschreibung

Die Erfindung betrifft eine NMR-Apparatur mit einem Magnetspulensystem zur Erzeugung eines homogenen Magnetfelds, welches mindestens eine NMR-Spule zur Modifikation des NMR-Magnetfelds umfasst, sowie mit einer stabilen Stromquelle, welche dazu eingerichtet ist, die NMR-Spule mit elektrischem Strom zu versorgen, und welche einen linearen Stromregler umfasst, der an ein erstes Ende der NMR-Spule elektrisch angeschlossen ist, wobei die Stromquelle eine digitale Spannungsquelle umfasst, welche an ein zweites Ende der NMR-Spule elektrisch angeschlossen ist, sodass die NMR-Spule als elektrischer Verbraucher zwischen den linearen Stromregler und die digitale Spannungsquelle geschaltet ist, wobei der lineare Stromregler über eine Regelleitung zur Regelung der elektrischen Spannung mit der digitalen Spannungsquelle verbunden ist, wobei die Stromquelle rauscharm und die digitale Spannungsquelle in Schalttechnologie ausgeführt ist, und wobei der lineare Stromregler so ausbildet ist, dass er die digitale Spannungsquelle derart regelt, dass die Spannung auf der Seite des linearen Teils der Anordnung in einem vorgewählten Arbeitsbereich liegt, sodass im linearen Teil der Anordnung eine möglichst geringe elektrische Leistung verbraucht wird.

Eine NMR-Apparatur mit diesen Merkmalen ist bekannt aus US 6 492 817 B2 (=Referenz [00]).

Eine ähnliche NMR-Apparatur mit nicht ganz so rauscharmer Stromquelle, bei der die digitale Spannungsquelle nicht in Schalttechnologie ausgeführt und der lineare Stromregler entsprechend anders ausbildet ist, wird in einem Artikel von NICK ARRANGO ET AL (=Referenz [0]) beschrieben.

NMR-Apparaturen mit Magnetspulensystemen zur Erzeugung eines homogenen Magnetfelds sind bereits seit den 1960er Jahren weltweit im Einsatz. Ein Beispiel ist etwa in der DE 101 04 365 C1 (=Referenz [1]) offenbart.

Eine stabile und rauscharme Stromquelle, welche dazu eingerichtet ist, eine NMR-Spule in einer solchen NMR-Apparatur mit elektrischem Strom zu versorgen, und welche einen linearen Stromregler umfasst, der an ein erstes Ende der NMR-Spule elektrisch angeschlossen ist, wird ausführlich beschrieben im technischen Handbuch der Anmelderin mit dem Titel «BSMS System for AVANCE NEO», Version 002, Kapitel 10 «SCB29», Unterkapitel 10.1-10.4, Seiten 83-90 (=Referenz [2]).

### Technischer Hintergrund der Erfindung

Die vorliegende Erfindung befasst sich ganz allgemein mit dem Bereich der Kernspinresonanz (nuclear magnetic resonance = "NMR"), insbesondere mit gekühlten, in der Regel im Betrieb supraleitenden NMR-Magnetsystemen, bei denen die Homogenität bzw. Stärke des NMR-Magnetfelds durch eine NMR-Spule noch weiter verbessert oder variiert wird.

Die NMR-Spektroskopie ist ein in der instrumentellen Analytik weitverbreitetes und leistungsfähiges Verfahren, mit dessen Hilfe bei einer zu untersuchenden Substanz, wie beispielsweise einem Kohlenwasserstoffmolekül oder einer bioanorganischen Komplexverbindung, die elektronische Umgebung einzelner Atome und die Wechselwirkung der einzelnen Atome mit den benachbarten Atomen untersucht werden kann. Auf diese Weise können zum Beispiel die Zusammensetzung, Struktur und Dynamik der zu untersuchenden Substanz aufgeklärt und ebenfalls die Konzentration der zu untersuchenden Substanz bestimmt werden.

Bei der NMR-Messung wird die Substanz einem starken statischen, homogenen Magnetfeld B₀ ausgesetzt, wodurch die Kernspins in der Substanz ausgerichtet werden. In die zu untersuchende Substanz werden dann hochfrequente elektromagnetische Impulse eingestrahlt. Die hierbei erzeugten, ebenfalls hochfrequenten elektromagnetischen Felder werden im NMR-Spektrometer detektiert. Daraus können dann Informationen über die Eigenschaften der untersuchten Substanz gewonnen werden.

Sowohl bei der hochauflösenden Magnetresonanz Spektroskopie wie auch in der bildgebenden Magnetresonanz sind die Anforderungen an die Magnetfeldhomogenität sehr hoch. Um die Homogenitätsspezifikationen zu erreichen, werden häufig elektrische Kryoshims eingesetzt. Deren Spulen erzeugen elementare Feldprofile. Mit geeigneten Strömen versehen können sie die Homogenität des NMR-Magneten am Probenort verbessern und so die Auflösung der Messung steigern.

Ein hochauflösendes NMR-Spektrometer mit einem supraleitenden NMR-Magnetspulensystem, das mit einem Pulsrohrkühler auf kryogene Temperaturen gekühlt wird, und das im Kaltbereich eines Kryostaten innerhalb eines Vakuumbehälters angeordnet ist, wird beschrieben in EP 0 780 698 B1 (= Referenz [3]).

Manchmal wird auch kaltes ferromagnetisches Material (beispielsweise Eisen- oder Stahllegierungen) als Shimelement zur Verbesserung der Homogenität verwendet, wie beispielsweise in der Druckschrift DE 10 2015 225 731 B3 (=Referenz [4]) beschrieben wird. Unabhängig davon, wie ein Magnet kalt geshimmt wird, bleibt am Schluss eine Restinhomogenität bestehen, die mittels eines weiteren Shimsystems korrigiert werden muss, welches außerhalb des Vakuumbehälters, typischerweise in der Magnetbohrung, angeordnete Shimelemente umfasst. Diese Shims können wie die Kryoshims entweder Shimspulen, die durch Shimströme bestromt werden, oder ferromagnetisches Material oder eine Kombination der beiden umfassen.

Aktuelle Shim-Stromquellen für NMR-Apparaturen basieren auf analoger Schaltungstechnik. Diese sind in der Regel stabil und rauscharm, aber aufgrund der gleichzeitig anliegenden hohen Spannungen und hohen Ströme im Strom-Regelkreis sehr ineffizient, d.h. es wird viel Abwärme erzeugt.

Die bereits eingangs zitierte Referenz [1] offenbart eine NMR-Apparatur mit einem Shimsystem als elektrischer Verbraucher der gattungsgemäßen Stromquelle. Allerdings bestehen auch bei dieser NMR-Apparatur die oben beschriebenen Probleme hinsichtlich der Effizienz aufgrund der gleichzeitig anliegenden hohen Spannungen und hohen Strömen im Strom-Regelkreis, d.h. es wird im NMR-Betrieb relativ viel Abwärme erzeugt.

Dies wird auch aus der ebenfalls bereits oben zitierten Referenz [2] deutlich, welche die -zumindest bislang optimale- für den Einsatz in der NMR-Apparatur von Referenz [1] einsetzbare, stabile und rauscharme Stromquelle im Detail zeigt. In Kapitel 10 von Referenz [2] wird ab Seite 83 die aktuell eingesetzte Stromquelle «SCB20» näher beschrieben. Insbesondere aus dem Blockschaltbild auf Seite 86 wird ersichtlich, dass auch hier die ganze Leistung vom linearen Teil der Anordnung bereitgestellt wird.

Dieser Stand der Technik stellt den benötigten Strom vollständig linear aus der Speisespannung bereit. Ist der resistive Anteil der Last -inklusive Versorgungskabel- klein, so wird der Leistungsanteil der nicht benötigten Spannung im linearen Verstärker dissipiert und in Wärme umgewandelt. Dies verschwendet einerseits elektrischen Strom und belastet die Speisung mehr als eigentlich nötig. Andererseits wird deswegen in der NMR-Apparatur eine besondere Vorrichtung zur Wärmeabfuhr erforderlich, in der Regel ein Kühlkörper, welcher die Stromquelle jedoch übermäßig groß macht. Weiter sind die typischen rauscharmen linearen Verstärker, die im benötigten Spannungsbereich arbeiten können, im Audio-Bereich angesiedelt. Diese werden aber immer mehr durch für die Audio-Anwendung optimierte Class-D Verstärker konkurrenziert, weshalb davon auszugehen ist, dass die hier verwendeten rauscharmen Linearverstärker über kurz oder lang nicht mehr kommerziell angeboten werden, zumindest aber demnächst nicht mehr wie bisher leicht erhältlich sind. Audio Class-D Verstärker erfüllen auch nicht den spezifischen Zweck hinsichtlich der Stromeinspeisung in eine NMR-Spule, wofür ein kontinuierlicher Strom benötigt wird.

### Aufgabe der Erfindung

Der vorliegenden Erfindung liegt demgegenüber die Aufgabe zugrunde, die Stromquelle für eine NMR-Spule in einer NMR-Apparatur mit den eingangs definierten Merkmalen mittels besonders einfach zu beschaffender, leicht zugänglicher technischer Mittel sowie möglichst kostengünstig so zu modifizieren, dass die NMR-Spule mit möglichst hohem elektrischem Wirkungsgrad mit einem einstellbaren, stabilen, besonders rauscharmen Strom versorgt wird, wobei insbesondere speziell für die Anwendung als Stromquelle für Shimspulen, aber ebenso auch für andere Anwendungen im Bereich der NMR die sehr hohe Homogenität des NMR-Magnetfelds selbst bei sich verändernden äußeren Verhältnissen weitestgehend stabil und konstant gehalten wird.

### Kurze Beschreibung der Erfindung

Diese relativ komplexe Aufgabe wird durch die vorliegende Erfindung auf ebenso überraschend einfache wie wirkungsvolle Weise dadurch gelöst, dass der lineare Stromregler einen elektrischen Verstärker zur Einspeisung von Strom in die NMR-Spule umfasst.

Der elektrische Verstärker wird vor allem gebraucht, um die benötigten niedrigen Werte des Rauschens zu erreichen.

Durch den Einsatz der erfindungsgemäß modifizierten Stromquelle kann jetzt die NMR-Spule in der NMR-Apparatur mit besonders hohem elektrischem Wirkungsgrad mit Strom beschickt werden.

Die erfindungsgemäße Lösung umfasst eine hocheffiziente, variable digitale Spannungsquelle in Schalttechnologie, einen einstellbaren stabilen und rauscharmen linearen Stromregler in gemischter Analog- und Digitaltechnologie, sowie die als elektrische Last von dieser Stromquelle gespeiste NMR-Spule. Die erfindungsgemäße Anordnung zeichnet sich durch einen gegenüber dem resistiven hohen induktiven Anteil der elektrischen Impedanz der Last aus. Die NMR-Spule als elektrische Last ist schaltungstechnisch bewusst *zwischen* der Spannungsquelle und dem Stromregler angeordnet. Durch den hohen induktiven Anteil der Last in Form einer Spule werden vor allem hochfrequente Störungen aus der geschalteten digitalen Spannungsquelle von dem empfindlichen, rauscharmen linearen Stromregler ferngehalten.

Ein wesentliches Merkmal der erfindungsgemäßen Lösung besteht in der hoch effizienten Bereitstellung einer Spannung an einem elektrischen Anschluss der als Last fungierenden NMR-Spule. Diese Spannung wird so geregelt, dass die Verlustleistung und damit die Abwärme in dem linearen Stromregler, angeschlossen am anderen elektrischen Anschluss der Last, minimiert wird. Zusammen mit der hoch effizienten Spannungserzeugung wird so die Effizienz des Gesamtsystems bestehend aus digitaler Spannungsquelle, linearem Stromregler und der NMR-Spule als elektrische Last optimiert und so die im NMR-Betrieb anfallende Verlustleistung minimiert.

Durch die Anordnung der induktiven Last zwischen der digitalen Spannungsquelle und dem linearen Stromregier werden Störungen durch die notwendigen Schaltvorgänge in der Spannungsquelle gefiltert und vom Stromregler ferngehalten. Dies erlaubt ursächlich eine hohe Reinheit des voreingestellten Stromes durch den linearen Stromregler und damit durch die NMR-Spule als Last. Die hohe Reinheit des voreingestellten Stromes und damit des erzeugten Magnetfeldes in der NMR-Spule ist eine wesentliche Voraussetzung für erfolgreiche NMR-Experimente.

Zum besseren Verständnis der vorliegenden Erfindung sei angemerkt, dass für die erfindungsgemäß gegenüber dem nächstkommenden Stand der Technik vorgeschlagenen Änderungen vor allem die gute kommerzielle Verfügbarkeit des Verstärkers, der verringerte Platzbedarf der Anordnung sowie deren deutlich erhöhte elektrische Effizienz vorteilhaft sind.

Idealerweise würde man den Strom direkt aus der Speisespannung geschaltet bereitstellen. Für das bei NMR-Anwendungen erforderliche niedere Rauschen braucht es aber weiterhin einen linearen Regler, welcher auch für die Stabilität wünschenswert ist. Dieser soll jedoch nur noch einen beschränkten Spannungsabfall machen, womit ein geringer Anteil der elektrischen Leistung im Linearregler verbraucht wird. Zudem sind Verstärker mit einem kleineren maximalen Spannungshub als der Speisespannung besser kommerziell auf dem Markt erhältlich.

Wird der lineare Stromregler direkt hinter die geschaltete Spannungsquelle geschaltet, so muss der Linearregler fliegend operieren.

Verwendet man mehrere effiziente Stromquellen für ein NMR-Spektrometer, wie z.B. für den Betrieb mehrerer Shim-Spulen erforderlich, so wäre der Linearregler jeder Stromquelle separat auszuführen, separat zu isolieren und separat mit einer Versorgungsspannung zu speisen. Oftmals braucht man mehr als eine geschaltete Speisung pro Stromquelle, z.B. je eine pro Speiseanschluss des Linearreglers, manchmal sogar noch mehr. Dies ist einerseits mit ganz erheblichen Kosten verbunden, andererseits braucht diese Lösung so viel Platz, dass der angestrebte Größenvorteil durch die bessere Effizienz nicht mehr gegeben ist.

Die erfindungsgemäße Kern-Idee ist daher, den Linearregler auf der Ground-Seite der Spule anzubringen, während auf der anderen Seite die digitale Spannungsquelle ein Spannungspotential oberhalb bzw. unterhalb der Ground-Spannung zur Verfügung stellt. Als Ground wird hier die elektrische Masse oder das Massenpotential verstanden.

Insbesondere bei Verwendung mehrerer effizienter Stromquellen können sich deren Linearregler dann der gleichen Speisung bedienen. Die Ansteuerung kann sowohl bei den DACs wie auch den ADCs und den Operationsverstärkern über mehrkanalige und nicht zu isolierende Bauteile erfolgen. Diese Bauelemente sind beispielweise Halbleiterbauelemente, die eine Mehrzahl von ADCs, DACs und/oder Operationsverstärkern mit entsprechenden Anschlusskontakten enthalten. Auf diese Weise lassen sich Funktionen verschiedener linearer Stromregler in gemeinsamen Bauelementen zusammenfassen. Dies spart bedeutend Platz und Kosten. Die große Induktivität der NMR-Spule hilft zudem, den Strom zusätzlich zu filtern, bevor er den empfindlichen Linearregler erreicht.

Der lineare Stromregler kann einen eingeschränkten Spannungsbereich haben, und zwar bisweilen einen viel kleineren als derjenige der digitalen Spannungsquelle. Dieser Spannungsbereich des linearen Stromreglers darf dann nicht überschritten werden - im Gegensatz zum nächstkommenden Stand der Technik, wo der Stromregler den ganzen Spannungsbereich abdeckt.

In diesem Fall muss die digitale Spannungsquelle so geregelt werden, dass beim gewünschten Strom dieser Spannungsbereich eingehalten wird. Dies gilt auch in der transienten Phase, während der Strom durch die NMR-Spule auf den Zielstrom gebracht wird. Erreicht wird dies durch eine langsame Änderung des Stromes durch den linearen Stromregler und - basierend auf einer Spannungsmessung auf der Ground-Seite der NMR-Spule - der digitalen Nachregelung der durch die digitale Spannungsquelle erzeugten Spannung.

Wenn der Zielstrom erreicht ist, wird die digitale Spannungsquelle innerhalb ihres digitalen Rasters so eingestellt, dass der Spannungsabfall über dem linearen Teil der Stromquelle möglichst klein ist, mit einer definierten kleinen Marge für die Regelung des linearen Stromreglers. Dies bedeutet, bei «positiven» Strömen liegt die Spannung am unteren Ende, bei «negativen» Strömen am oberen Ende des Spannungsbereichs des linearen Stromreglers. Als «positiv» wird hier ein Strom bezeichnet, der in den linearen Teil der Stromquelle hineinfließt.

Um die vorliegende Erfindung noch weiter zu verdeutlichen, sollen im Folgenden einige zentrale Begriffe näher erläutert werden:

### Stabile und rauscharme Stromquelle:

Das effektiv gemessene Rauschen bei 1A und 10Ohm resistiver Last von 1Hz-100Hz ist kleiner als 1uArms, von 1Hz-200kHz kleiner als 20uArms. Die Vorgabe bei der vorliegenden Erfindung ist, das Rauschen so klein zu halten, wie mit vertretbarem Aufwand machbar. Damit dies möglich ist, braucht die Gesamtschaltung im ganzen Frequenzbereich eine genügend gute Unterdrückung von Störungen. Dies wird unten auch noch unter den Erläuterungen zum Vorregler detailliert erklärt.

### Linearer Stromregler:

Ein Stromregler mit linearer Ausgangsstufe ist ein Linear-Regler. Der lineare Stromregler kann dabei analog und/oder digital ausgeführt sein. Im Falle der vorliegenden Erfindung ist er beides: Ein «schneller» analoger Stromregler wird von einem langsameren digitalen Regelkreis angesteuert.

Für die Stabilität des linearen Stromreglers sind folgende Grenzwerte anzustreben: Gain drift < 11 ppm/°C und Offset drift < +/- 1 uA/°C.

### Digitale Spannungsquelle in Schalttechnologie:

Eine digitale Spannungsquelle in Schalttechnologie ist ein Gleichspannungswandler, der durch den Einsatz von geschalteten Elementen und einem oder mehreren Energiespeichern eine zugeführte Gleichspannung effizient in eine andere Gleichspannung umwandelt. Im Falle der vorliegenden Erfindung wird normalerweise ein Abwärtswandler eingesetzt, also eine Reduzierung gegenüber der Speisespannung erreicht.

### Bevorzugte Ausführungsformen und Weiterbildungen der Erfindung

Bei einer ganz besonders bevorzugten Klasse von Ausführungsformen der erfindungsgemäßen NMR-Apparatur ist die digitale Spannungsquelle gepulst betreibbar.

Die Wirkungsweise ist die einer digitalen Spannungsquelle in Schalttechnologie. Gepulste Spannungsquellen, auch als geschaltete Spannungsquellen bezeichnet, können sehr effizient sein und haben demzufolge eine geringe Wärmeerzeugung bei gleicher Ausgangsleistung.

Bei bevorzugten Weiterbildungen dieser Klasse von Ausführungsformen liegt die Pulsfrequenz der digitalen Spannungsquelle in einem Bereich zwischen 10kHz und 1GHz, vorzugsweise zwischen 30kHz und 200kHz.

Bei zu tiefen Frequenzen (< 10 kHz) werden Filterelemente, die zwischen digitaler Spannungsquelle und NMR-Spule anzuordnen sind, zu groß und zu langsam. Bei zu hohen Frequenzen (> 1 GHz) werden die Schaltverluste zu groß, die Effizienz wird schlechter und es entsteht zu viel Wärme. Letzteres wird aber durch den technologischen Fortschritt laufend verbessert. Höhere Frequenzen sind im Prinzip bevorzugt, da die Filter kleiner und/oder besser sein können.

Bei weiteren vorteilhaften Weiterbildungen dieser Klasse von Ausführungsformen kann die digitale Spannungsquelle pulsweitenmoduliert betrieben werden. Dabei wird bei konstanter Speisespannung der digitalen Spannungsquelle der Tastgrad (Verhältnis von Einschaltzeit zur Periodendauer) vergrößert oder verkleinert. Der Tastgrad bestimmt damit die an der NMR-Spule anliegende Spannung.

Bei einem gegebenen Tastgrad wird aus einer vorhandenen Eingangsspannung eine definierte Ausgangsspannung erzeugt. Die Verwendung von Pulsweitenmodulation ermöglicht eine einfache Implementierung und gute Vorhersagbarkeit der Ausgangsspannung der digitalen Spannungsquelle. Außerdem gibt die Pulsfrequenz der digitalen Spannungsquelle eine klar definierte Grundfrequenz vor, die sich durch feste Bauelemente filtern lässt.

Andere, ebenfalls vorteilhafte Weiterbildungen sind dadurch gekennzeichnet, dass die digitale Spannungsquelle einen Filter (in der Regel einen analogen Filter) mit mindestens einem induktiven Element, insbesondere einer oder mehreren Spulen, und mit einem oder mehreren parallel gegen Masse geschalteten kapazitiven Elementen, insbesondere Kondensatoren, aufweist, wobei der Filter dazu ausgebildet ist, die Spannung der gepulsten digitalen Spannungsquelle zu glätten. Vorzugsweise ist dieser Filter direkt zwischen digitaler Spannungsquelle und NMR-Spule angeordnet.

Das erste Glied des Filters ist beispielsweise eine PWM-Speicherdrossel und ein Kondensator zur Herausfilterung des DC-Anteils der Rechteckspannung der digitalen Spannungsquelle. Zur Bedämpfung des Filters kann zudem ein Snubber vorgesehen sein.

Das zweite Glied umfasst zum Beispiel eine Filterdrossel und einen Kondensator zur besseren Filterung der PWM-Frequenz sowie einen weiteren Snubber zur Bedämpfung des Filters. Dabei ist die PWM-Frequenz die Pulsfrequenz der gepulsten Spannungsquelle.

Das erste Glied sollte dabei ein induktives und/oder kapazitives Element enthalten. Das zweite Glied könnte auch anders als mit einem LC-Glied realisiert werden, z.B. linear (was aber entsprechend mehr Verlust bedeuten kann). Oder das zweite LC-Glied wird in das erste Glied integriert, womit man es weglassen könnte. Entsprechend würde dann das erste Glied etwas größer. Die Aufteilung in zwei Teile hat den Vorteil, dass das zweite Glied räumlich weiter vom PWM-Glied (welches z.B. mehrere Stromquellen gleichzeitig bedient) entfernt sein kann und somit die einzelnen Spannungen besser gegen die Störungen durch die anderen Stromquellen geschirmt werden können.

Eine weitere vorteilhafte Ausführungsform der erfindungsgemäßen NMR-Apparatur zeichnet sich dadurch aus, dass die digitale Spannungsquelle dazu eingerichtet ist, sowohl negative als auch positive Spannungswerte bereitzustellen.

Die Richtung des Stroms durch die NMR-Spule ist abhängig vom Vorzeichen der Spannungswerte. Dies ist vorteilhaft, weil damit das Magnetfeld der NMR-Spule in beide Richtungen beeinflussbar und variierbar ist.

Besonders bevorzugt ist auch eine Klasse von Ausführungsformen der Erfindung, welche sich dadurch auszeichnen, dass der lineare Stromregler einen Shunt-Widerstand und einen diesen überbrückenden AD-Wandler zur Messung des durch die NMR-Spule fließenden Stroms umfasst.

Da der Strom digital eingestellt wird, muss er auch digital gemessen werden können.

Eine übliche Art der Strommessung ist diejenige mittels Shunt-Widerstand. Alternative Arten der Strommessung sind nicht genügend stabil oder präzise.

Vorteilhaft sind Weiterbildungen dieser Ausführungsformen, bei denen der AD-Wandler mit einer digitalen Regeleinheit verbunden ist.

Durch eine geeignete Programmierung dieser digitalen Regeleinheit kann erreicht werden, dass der analoge Stromregler die digitale Spannungsquelle derart regelt, dass die Spannung auf der Seite des analogen Teils der Anordnung in einem vorgewählten Arbeitsbereich liegt. Dadurch wird im analogen Teil der Anordnung eine besonders geringe elektrische Leistung verbraucht.

Im digitalen Raum lassen sich diverse regeltechnische Optimierungen als Programme verwirklichen. Auch sind nachträgliche Anpassungen der Regelung einfacher.

Die digitale Spannungsquelle muss sowieso digital angesprochen werden, weshalb ein digitaler Regler Vorteile aufweist.

Besonders bevorzugt sind Weiterbildungen der oben beschriebenen Ausführungsform der Erfindung, welche sich dadurch auszeichnen, dass die digitale Regeleinheit über einen DA-Wandler mit dem elektrischen Verstärker sowie vorzugsweise über die Regelleitung mit der digitalen Spannungsquelle verbunden ist.

Der elektrische Verstärker funktioniert analog; die digitale Regeleinheit hingegen digital. Um den elektrischen Verstärker anzusteuern, wird ein DA-Wandler verwendet, um die digital-analog Grenze zu überschreiten. Damit kann auch die nötige Stabilität und Auflösung erreicht werden.

Bei einer weiteren, besonders bevorzugten Klasse von Ausführungsformen der erfindungsgemäßen NMR-Apparatur erfolgt die Ansteuerung der digitalen Spannungsquelle nach einem festgelegten zeitlichen Raster. Werden mehrere Stromquellen räumlich benachbart angeordnet, so kann die gegenseitige Störung verringert werden, wenn die digitalen Spannungsquellen zeitlich synchron aktiv geschaltet werden.

Indem die Ansteuerung in einem fixen zeitlichen Raster erfolgt, vermeidet man Störungen zwischen den mehreren gleichartigen, effizienten Stromquellen. Durch das fixe zeitliche Raster entstehen diskrete Spannungsniveaus. Diese diskreten Spannungsniveaus der digitalen Spannungsquellen werden durch den linearen Stromregler ausgeglichen.

Bei einer Klasse von besonders vorteilhaften Weiterbildungen dieser Ausführungsformen wird als zeitliches Raster ein ganzzahliger Teiler eines Messintervalls des AD-Wandlers gewählt, oder das zeitliche Raster wird so gewählt wird, dass ein digitales Filterelement die Frequenz des zeitlichen Rasters möglichst gut unterdrückt, damit sie nicht störend auf den Strom durch die NMR-Spule wirkt.

Gängige AD-Wandler haben diese digitale Filterfunktion schon integriert. Das Filter im ADC kann deshalb auf das Raster abgestimmt werden und/oder umgekehrt.

Eine vorteilhafte Variante dieser Klasse von Weiterbildungen zeichnet sich dadurch aus, dass mindestens ein Vorregler für die Spannungsversorgung der digitalen Spannungsquelle vorhanden ist.

Der in der Regel in die digitale Spannungsquelle integrierte Vorregler ("power supply stabilizer") dient zur weiteren Unterdrückung von Störungen im mittleren Frequenzbereich (10 Hz - 10 kHz), die aus der Energie-Versorgung der Spannungsquelle herrühren. Die PWM-Filter filtern hingegen nur Frequenzen oberhalb 10 kHz.

Jede Stromquelle soll rauscharm sein, über einen weiten Frequenzbereich möglichst wenig Störungen erzeugen und sehr stabil sein (=möglichst gar keine Störungen bei tiefsten Frequenzen).

Im mittleren Frequenzbereich ist die Wirkung des linearen Reglers nicht mehr genügend gut, ebenso wirkt dort das analoge Filter noch nicht richtig. Um Störungen vom Power Supply der digitalen Spannungsquelle im mittleren Frequenzbereich von der Last fernzuhalten, wird deshalb die Speisespannung der digitalen Spannungsquelle vorgeregelt.

Weitere vorteilhafte Ausführungsformen der Erfindung sind dadurch gekennzeichnet, dass die Stromquelle so ausgestaltet ist, dass der durch die NMR-Spule fließende elektrische Strom im Bereich -20A bis +20A, insbesondere im Bereich -1A bis +1A, variiert werden kann.

Der Strom durch die als elektrische Last geschaltete NMR-Spule in einem gegebenen Bereich entsprechend den Anforderungen des NMR-Systems kann mit hoher Auflösung und Genauigkeit (z.B. bis zu 20Bit) eingestellt und gegebenenfalls über die Zeit verändert werden. Zusammen mit der NMR-Spule können so auch kleinste, durch externe Ereignisse begründete Änderungen im NMR-Magnetfeld der NMR-Apparatur korrigiert werden.

Typisch sind folgende Eckdaten für eine stabile und rauscharme Stromquelle:
- Schaltfrequenz: > 10kHz (bei gepulstem Betrieb)
- Strom: < +/-1A pro Stromquelle
- Spannungsversorgung: +/- 24V
- Rauschen @1A, 10Ohm resistive Last: 1Hz-100Hz: <1uArms, 1Hz-200kHz: <20uArms
- Last: 0-20Ohm, 0-1mH
- Auflösung: > 20bit
- Stabilität: Gain drift < 11 ppm/°C und Offset drift < +/- 1 uA/°C

In der Praxis bewähren sich insbesondere Ausführungsformen der Erfindung, bei welchen die NMR-Spule als Spule zum Shimmen der NMR-Apparatur und/oder zur Homogenisierung des vom NMR-Magnetsystem erzeugten NMR-Magnetfelds oder zum Variieren des NMR-Magnetfeldes, insbesondere mittels einer Flusspumpe, ausgestaltet ist.

Es kann vorkommen, dass beispielsweise beim Betrieb einer Vielzahl von Shim-Spulen mehrere Dutzend solcher Stromquellen nötig sind, deren Strom- und Spannungsbedarf im Vorhinein unbekannt ist. Erst in der Endanwendung wird klar, welche Quelle welche Shim-Spule mit welchem Strom treiben muss.

Bei der Flusspumpe ist die Spannung relativ klein, dafür ist der Maximalstrom zeitweise umso größer. Eine Flusspumpe in einer NMR-Apparatur dient dazu, eine Abnahme des Hauptmagnetfeldes des NMR-Magnetsystems durch induktive Einkopplung zu kompensieren.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: ein schematisches Blockdiagramm der erfindungswesentlichen Teile einer erfindungsgemäß modifizierten NMR-Apparatur; und
- Fig. 2: ein schematisches Blockschaltbild einer bevorzugten Ausführungsform der Erfindung.

Generell befasst sich die vorliegende Erfindung mit einer modifizierten **NMR-Apparatur 10,** die ein -in der Zeichnung nicht eigens dargestelltes- NMR-Magnetsystem zur Erzeugung eines homogenen Magnetfelds enthält, welches mindestens eine **NMR-Spule 11** zur Modifikation des NMR-Magnetfelds umfasst. Außerdem ist eine stabile und rauscharme Stromquelle vorhanden, welche dazu eingerichtet ist, die NMR-Spule 11 mit elektrischem Strom zu versorgen, und welche einen **linearen Stromregler 12** umfasst, der an ein erstes Ende der NMR-Spule 11 elektrisch angeschlossen ist.

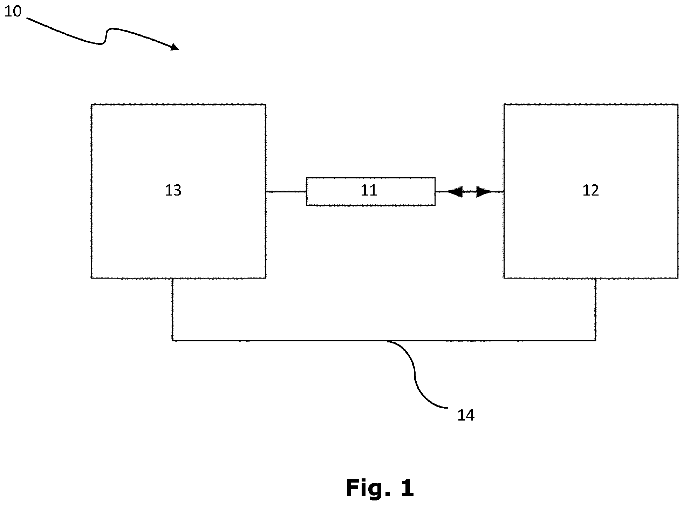

Wie in **Fig. 1** gezeigt, zeichnet sich die erfindungsgemäße NMR-Apparatur 10 gegenüber dem Stand der Technik dadurch aus, dass die Stromquelle eine getaktete **digitale Spannungsquelle 13 in Schalttechnologie** umfasst, welche an ein zweites Ende der NMR-Spule 11 elektrisch angeschlossen ist, sodass die NMR-Spule 11 als elektrischer Verbraucher zwischen den linearen Stromregler 12 und die digitale Spannungsquelle 13 geschaltet ist. Der lineare Stromregler 12 ist über eine **Regelleitung 14** zur Regelung der elektrischen Spannung mit der digitalen Spannungsquelle 13 verbunden. Der lineare Stromregler 12 ist nach der vorliegenden Erfindung dazu ausbildet, die digitale Spannungsquelle 13 derart zu regeln, dass die Spannung auf der Seite des linearen Teils der Anordnung in einem vorgewählten Arbeitsbereich(z.B. 0 bis 3.3 V) liegt, sodass im linearen Teil der Anordnung eine möglichst geringe elektrische Leistung verbraucht wird.

In der Regel ist die digitale Spannungsquelle 13 gepulst betreibbar, wobei die Pulsfrequenz in einem Bereich zwischen 10kHz und 1GHz, vorzugsweise zwischen 30kHz und 200kHz, liegt. In einem konkret verwirklichten Ausführungsbeispiel der Erfindung wird eine Frequenz von 104,1666kHz eingesetzt.

Insbesondere kann die digitale Spannungsquelle 13 pulsweitenmoduliert betrieben werden. Die Höhe der Ausgangsspannung wird durch die Pulsweiten-Modulierung der digitalen Spannungsquelle 13 bestimmt. Den Strom durch die NMR-Spule 11, insbesondere dessen Feinabgleich, bestimmt der lineare Stromregler 12. Einzig hochfrequente Störungen kann der Stromregler 12 in der Regel nicht genügend gut ausregeln.

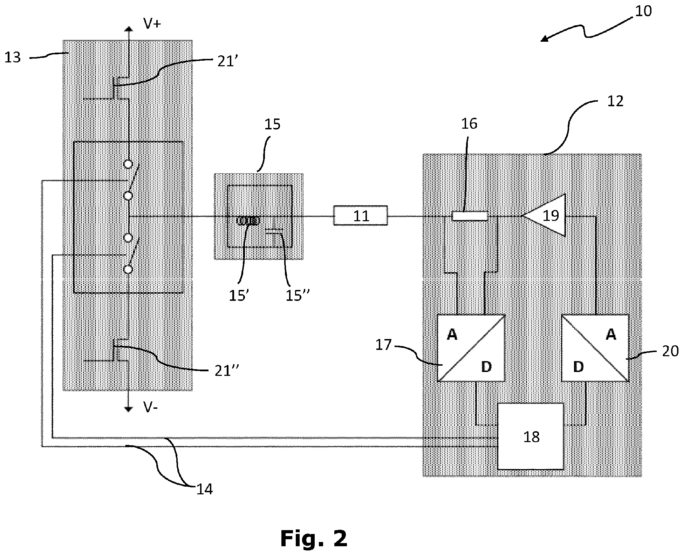

**Fig. 2** zeigt ein Blockschaltbild einer besonders bevorzugten Ausführungsform der erfindungsgemäßen NMR-Apparatur 10.

Die digitale Spannungsquelle 13 ist dazu eingerichtet, sowohl positive als auch negative Spannungswerte bereitzustellen, was in der Zeichnung aus den Symbolen V+ und V- an den beiden Spannungseingängen ersichtlich wird. In der Regel handelt es sich um Spannungen zwischen +24V und -24V. Dieser Spannungsbereich ist damit größer als der vorgewählte Spannungsbereich des linearen Anteils der Schaltung.

Wie in Fig. 2 anschaulich dargestellt, weist die digitale Spannungsquelle 13 bei dieser Ausführungsform einen **Filter 15** (nachfolgend auch «analoger Filter») mit mindestens einem induktiven Element, insbesondere einer oder mehreren **Spulen 15',** und mit einem oder mehreren parallel gegen Masse geschalteten kapazitiven Elementen, insbesondere **Kondensatoren 15",** auf. Der Filter 15 ist dazu ausgebildet, die Spannung der digitalen Spannungsquelle 13 zu glätten. In Fig. 2 ist der Filter 15 räumlich getrennt von der digitale Spannungsquelle 13 dargestellt; er kann aber auch integriert in diese ausgeführt sein. In jedem Fall ist er aber zwischen Spannungsquelle und NMR-Spule angeordnet.

Der lineare Stromregler 12 umfasst in der gezeigten Ausführungsform einen **Shunt-Widerstand 16** und einen diesen überbrückenden **AD-Wandler 17** zur Messung des durch die NMR-Spule 11 fließenden Stroms. Der AD-Wandler 17 ist mit einer **digitalen Regeleinheit 18** verbunden.

Des Weiteren umfasst der lineare Stromregler 12 einen **elektrischen Verstärker 19** zur Einspeisung von Strom in die NMR-Spule 11.

Die digitale Regeleinheit 18 ist über einen **DA-Wandler 20** mit dem elektrischen Verstärker 19 sowie vorzugsweise über die Regelleitung 14 mit der digitalen Spannungsquelle 13 verbunden.

Die Ansteuerung der digitalen Spannungsquelle 13 erfolgt nach einem festgelegten zeitlichen Raster, so dass sich mehrere gleichzeitig eingesetzte Stromquellen nicht gegenseitig stören. Als zeitliches Raster kann ein ganzzahliger Teiler eines Messintervalls des AD-Wandlers 17 (nachfolgend auch »ADC») gewählt werden. Das zeitliche Raster kann aber so gewählt werden, dass ein digitales Filterelement die Frequenz des zeitlichen Rasters möglichst gut unterdrückt. Das Messintervall des AD-Wandlers entspricht der ADC-Frequenz im Frequenzraum.

Werden beliebige PWM-Frequenzen oder beliebige damit erzeugte Spannungen zugelassen, so sind auf dem Spannungssignal der digitalen Spannungsquelle alle diese beliebigen Frequenzen vorhanden, sowie Mischfrequenzen mit den anderen Stromquellen. Diese können mit dem analogen Filter nicht genügend gut herausgefiltert werden, zumindest haben solche Filter entweder keinen Platz in der Anordnung oder sind zu teuer oder verbrauchen zu viel Leistung. Unkontrollierte Mischfrequenzen könnten direkt zu Störungen in der NMR-Messung führen. Insbesondere für die Shim-Anwendung ist aber die Stabilität der Ströme ganz wesentlich.

Vor dem ADC sollte eigentlich ein Nyqvist-Filter vorhanden sein, das Frequenzen über der halben ADC-Frequenz herausfiltert. Da aber im NMR-Betrieb extrem präzise gemessen werden muss, würde dieses Filter einen zu großen Fehler machen, oder der Aufwand für permanente Nach-Kalibrierung wäre zu teuer/komplex, wenn überhaupt möglich. Deshalb wird in der Regel kein Nyqvist-Filter verwendet. Im ADC entstehen so Mischfrequenzen, die einen Messfehler verursachen. Gängige Sigma-Delta ADCs haben integrierte digitale Filter, die ausgewählte Frequenzen (und Vielfache davon) sehr gut unterdrücken können.

Die größten Messfehler entstehen dort, wo die größten Störungen sind, d.h. vor allem bei der PWM-Frequenz der digitalen Spannungsquelle (und Vielfachen davon), welche vom analogen Filter nicht perfekt gefiltert werden kann. PWM-Frequenz und ADC-Filter sind deshalb aufeinander abgestimmt, so dass der ADC wegen der PWM-Störungen keinen Messfehler macht.

In der erfindungsgemäßen Anordnung sollte mindestens ein Vorregler für die Spannungsversorgung der digitalen Spannungsquelle 13 vorhanden sein. Die Ausführungsform gemäß Fig. 2 zeigt zwei Vorregler 21'; 21", welche hier in der digitalen Spannungsquelle 13 räumlich integriert dargestellt sind, aber bei anderen Ausführungsformen auch von der digitalen Spannungsquelle 13 getrennt angeordnet sein können, wie etwa der Filter 15 in Fig. 2.

Die Stromquelle der erfindungsgemäß modifizierten NMR-Apparatur 10 wird in der Regel so ausgestaltet sein, dass der durch die NMR-Spule 11 fließende elektrische Strom im Bereich -20A bis +20A, insbesondere im Bereich -1A bis +1A, variiert werden kann.

Bei besonders wichtigen Anwendungen der Erfindung ist die NMR-Spule 11 als Spule zum Shimmen der NMR-Apparatur 10 und/oder zur Homogenisierung des vom NMR-Magnetsystem erzeugten NMR-Magnetfelds ausgestaltet. Sie kann aber beispielsweise auch zum Variieren des NMR-Magnetfeldes eingesetzt werden. Die Vorrichtung wirkt dann als Flusspumpe.

Die Höhe des Stroms wird durch den linearen Stromregler bestimmt. Dies geschieht so lange, wie die Spannungsquelle eine Spannung erzeugt, die unter Berücksichtigung von Strom und Last eine Spannung beim Operationsverstärker ergibt, die in dessen zulässigem Bereich liegt. Andernfalls ist der Strom undefiniert, nicht geregelt, stabil und rauscharm, und der Stromregler kann ohne Schutzschaltung zerstört werden. Der Stromregler hält im Betrieb weniger Spannung aus, als die digitale Spannungsquelle erzeugen kann.

Typischerweise ist der elektrische Verstärker als ein oder mehrere miteinander verschaltete Operationsverstärker ausgebildet. Die meisten Operationsverstärker können Strom einspeisen oder auch senken, d.h. der Strom kann auch in die Spitze des den Operationsverstärker im Schaltdiagramm darstellenden Dreiecks hineinfließen, was im vorliegenden Fall als «positiver» Strom bezeichnet wird.

Die Masse ist für die Schaltung auf den ersten Blick nicht relevant:
Ein positiver Strom fließt von der +V Speisung, wird auf eine tiefere Spannung gewandelt, fließt durch die NMR-Spule und danach in die negative Speisung vom Operationsverstärker.

Ein negativer Strom fließt von der positiven Speisung vom Operationsverstärker durch die NMR-Spule in die digitale Spannungsquelle hinein und durch die -V Speisung weg.

Hier kommt die Masse erst mal nicht vor, was auch Sinn macht, da man beiderseits der NMR-Spule mit verschiedenen Potenzialen/Spannungen den gleichen Strom erzielen kann, solange nur die Spannungsdifferenz gleich groß ist.

Es gibt aber noch Randbedingungen, und da spielt die Masse dann wieder eine Rolle:
- Die von der gepulsten digitalen Spannungsquelle erzeugte Spannung muss gegen irgendein Potenzial gefiltert/stabilisiert werden. Vorteilhaft ist dieses Potential die Masse.
- Um eine Speisung zu sparen, und um die Operationsverstärker Groundbezogen ansteuern zu können, werden die linearen Endstufen, also die Leistungsverstärker nicht symmetrisch gespeist, d.h. die negative Speisung des Leistungsverstärkers ist hier die Masse.

Das Operationsverstärker-Symbol im Blockdiagramm steht aber nicht nur für einen einzelnen Leistungsverstärker. Im Normalfall braucht man noch weitere Operationsverstärker, welche nicht den ganzen Strom tragen. Diese können dann trotzdem wieder eine +/- Speisung benötigen, welche aber nicht so viel Strom zu liefern braucht wie die Speisung der Leistungsverstärker.

### Bezugszeichenliste:

- 10: NMR-Apparatur
- 11: NMR-Spule
- 12: linearer Stromregler
- 13: digitale Spannungsquelle in Schalttechnologie
- 14: Regelleitung
- 15: Filter
- 15': induktive Elemente
- 15": kapazitive Elemente
- 16: Shunt-Widerstand
- 17: AD-Wandler
- 18: digitale Regeleinheit
- 19: elektrischer Verstärker
- 20: DA-Wandler
- 21'; 21": Vorregler

### Referenzliste

Für die Beurteilung der Patentfähigkeit in Betracht gezogene Publikationen:
[00] US 6492 817 B2
[0] NICK ARRANGO ET AL: : Open-source, low-cost, flexible, current feedback-controlled driver circuit for local B0 shim coils and other applications. Veröffentlichungsdatum: 7 February 2022. Quelle (URL: https://cds.ismrm.orq/protected/16MProceedinqs/PDFfiles/1157.html) [recherchiert am 27.07.2023]
[1] DE 101 04 365 C1 ≈ GB 2 411 238 B ≈ US 2005/0174118 A1
[2] Technisches Handbuch der Anmelderin mit dem Titel «BSMS System for AVANCE NEO», Version 002, Kapitel 10 «SCB20», Unterkapitel 10.1-10.4, Seiten 83-90
[3] EP 0 780 698 B1 ≈ US 5,744,959 A
[4] DE 10 2015 225 731 B3 ≈ EP 3 182 147 B ≈ US 9,766,312 B1 ≈ CN 106898452 B ≈ JP 6340403 B

## Patentansprüche

1. NMR-Apparatur (10) mit einem NMR-Magnetsystem zur Erzeugung eines NMR-Magnetfelds, welches mindestens eine NMR-Spule (11) zur Modifikation des NMR-Magnetfelds umfasst, sowie mit einer stabilen Stromquelle, welche dazu eingerichtet ist, die NMR-Spule (11) mit elektrischem Strom zu versorgen, und welche einen linearen Stromregler (12) umfasst, der an ein erstes Ende der NMR-Spule (11) elektrisch angeschlossen ist, wobei die Stromquelle eine digitale Spannungsquelle (13) umfasst, welche an ein zweites Ende der NMR-Spule (11) elektrisch angeschlossen ist, sodass die NMR-Spule (11) als elektrischer Verbraucher zwischen den linearen Stromregler (12) und die digitale Spannungsquelle (13) geschaltet ist, wobei der lineare Stromregler (12) über eine Regelleitung (14) zur Regelung der elektrischen Spannung mit der digitalen Spannungsquelle (13) verbunden ist, wobei die Stromquelle rauscharm und die digitale Spannungsquelle (13) in Schalttechnologie ausgeführt ist, und wobei der lineare Stromregler (12) so ausbildet ist, dass er die digitale Spannungsquelle (13) derart regelt, dass die Spannung auf der Seite des linearen Stromreglers (12) in einem vorgewählten Arbeitsbereich liegt, sodass im linearen Stromregler (12) eine möglichst geringe elektrische Leistung verbraucht wird,
**dadurch gekennzeichnet,**
der lineare Stromregler (12) einen elektrischen Verstärker (19) zur Einspeisung von Strom in die NMR-Spule (11) umfasst.

2. NMR-Apparatur nach Anspruch 1, **dadurch gekennzeichnet, dass** die digitale Spannungsquelle (13) gepulst betreibbar ist.

3. NMR-Apparatur nach Anspruch 2, **dadurch gekennzeichnet, dass** die Pulsfrequenz der digitalen Spannungsquelle (13) in einem Bereich zwischen 10kHz und 1GHz, vorzugsweise zwischen 30kHz und 200kHz, liegt.

4. NMR-Apparatur nach Anspruch 2 oder 3, **dadurch gekennzeichnet, dass** die digitale Spannungsquelle (13) pulsweitenmoduliert betrieben werden kann.

5. NMR-Apparatur nach Anspruch 2 oder 3, **dadurch gekennzeichnet, dass** die digitale Spannungsquelle (13) einen Filter (15) mit mindestens einem induktiven Element, insbesondere einer oder mehreren Spulen (15'), und mit einem oder mehreren parallel gegen Masse geschalteten kapazitiven Elementen, insbesondere Kondensatoren (15"), aufweist, wobei der Filter (15) dazu ausgebildet ist, die Spannung der digitalen Spannungsquelle (13) zu glätten.

6. NMR-Apparatur nach einem der vorhergehenden Ansprüche, **dadurch gekennzeichnet, dass** die digitale Spannungsquelle (13) dazu eingerichtet ist, sowohl negative als auch positive Spannungswerte bereitzustellen.

7. NMR-Apparatur nach einem der vorhergehenden Ansprüche, **dadurch gekennzeichnet, dass** der lineare Stromregler (12) einen Shunt-Widerstand (16) und einen diesen überbrückenden AD-Wandler (17) zur Messung des durch die NMR-Spule (11) fließenden Stroms umfasst.

8. NMR-Apparatur nach Anspruch 7, **dadurch gekennzeichnet, dass** der AD-Wandler (17) mit einer digitalen Regeleinheit (18) verbunden ist.

9. NMR-Apparatur nach Anspruch 8, **dadurch gekennzeichnet, dass** die digitale Regeleinheit (18) über einen DA-Wandler (20) mit dem elektrischen Verstärker (19) sowie vorzugsweise über die Regelleitung (14) mit der digitalen Spannungsquelle (13) verbunden ist.

10. NMR-Apparatur nach einem der vorhergehenden Ansprüche, **dadurch gekennzeichnet, dass** die Ansteuerung der digitalen Spannungsquelle (13) nach einem festgelegten zeitlichen Raster erfolgt, so dass sich mehrere gleichzeitig eingesetzte Stromquellen nicht gegenseitig stören.

11. NMR-Apparatur nach Anspruch 10 sowie einem der Ansprüche 7 oder 8, **dadurch gekennzeichnet, dass** als zeitliches Raster ein ganzzahliger Teiler eines Messintervalls des AD-Wandlers (17) gewählt wird, oder dass das zeitliche Raster so gewählt wird, dass ein digitales Filterelement die Frequenz des zeitlichen Rasters möglichst gut unterdrückt.

12. NMR-Apparatur nach Anspruch 11, **dadurch gekennzeichnet, dass** mindestens ein Vorregler (21'; 21") für die Spannungsversorgung der digitalen Spannungsquelle (13) vorhanden ist.

13. NMR-Apparatur nach einem der vorhergehenden Ansprüche, **dadurch gekennzeichnet, dass** die Stromquelle so ausgestaltet ist, dass der durch die NMR-Spule (11) fließende elektrische Strom im Bereich -20A bis +20A, insbesondere im Bereich -1A bis +1A, variiert werden kann.

14. NMR-Apparatur nach einem der vorhergehenden Ansprüche, **dadurch gekennzeichnet, dass** die NMR-Spule (11) als Spule zum Shimmen der NMR-Apparatur (10) und/oder zur Homogenisierung des vom NMR-Magnetsystem erzeugten NMR-Magnetfelds oder zum Variieren des NMR-Magnetfeldes, insbesondere mittels einer Flusspumpe, ausgestaltet ist.

## Claims

1. An NMR apparatus (10) having an NMR magnet system for generating an NMR magnetic field, which comprises at least one NMR coil (11) for modifying the NMR magnetic field, and comprising a stable current source which is configured to supply the NMR coil (11) with electric current and which comprises a linear current controller (12) that is electrically connected to a first end of the NMR coil (11), wherein the current source is comprising a digital voltage source (13) that is electrically connected to a second end of the NMR coil (11) such that the NMR coil (11) is interposed as an electric consumer between the linear current controller (12) and the digital voltage source (13), wherein the linear current controller (12) is connected to the digital voltage source (13) via a control line (14) for controlling the electric voltage, wherein the current source is a low-noise current source and the digital voltage source (13) is designed in switching technology, and wherein the linear current controller (12) is designed to control the digital voltage source (13) such that the voltage on the side of the linear current controller (12) is in a preselected working range so that the lowest possible electric power is consumed in the linear current controller (12)
**characterized in**
**that** the linear current controller (12) comprises an electric amplifier (19) for feeding current into the NMR coil (11).

2. The NMR apparatus according to claim 1, **characterized in that** the digital voltage source (13) can be operated in a pulsed manner.

3. The NMR apparatus according to claim 2, **characterized in that** the pulse frequency of the digital voltage source (13) is in a range between 10 kHz and 1 GHz, preferably between 30 kHz and 200 kHz.

4. The NMR apparatus according to claim 2 or 3, **characterized in that** the digital voltage source (13) can be operated using pulse width modulation.

5. The NMR apparatus according to claim 2 or 3, **characterized in that** the digital voltage source (13) has a filter (15) having at least one inductive element, in particular one or more coils (15'), and having one or more capacitive elements, in particular capacitors (15"), connected in parallel, to ground, the filter (15) being designed to smooth the voltage of the digital voltage source (13).

6. The NMR apparatus according to any one of the preceding claims, **characterized in that** the digital voltage source (13) is designed to provide both negative and positive voltage values.

7. The NMR apparatus according to any one of the preceding claims, **characterized in that** the linear current controller (12) comprises a shunt resistor (16) and an A/D converter (17) across said shunt resistor for measuring the current flowing through the NMR coil (11).

8. The NMR apparatus according to claim 7, **characterized in that** the A/D converter (17) is connected to a digital control unit (18).

9. The NMR apparatus according to claim 8, **characterized in that** the digital control unit (18) is connected to the electric amplifier (19) via a D/A converter (20) and preferably to the digital voltage source (13) via the control line (14).

10. The NMR apparatus according to any one of the preceding claims, **characterized in that** the digital voltage source (13) is actuated according to a fixed time grid such that multiple current sources used simultaneously do not interfere with one another.

11. The NMR apparatus according to claim 10 and to one of claims 7 or 8, **characterized in that** an integer divisor of a measuring interval of the A/D converter (17) is selected as the time grid, or that the time grid is selected such that a digital filter element suppresses the frequency of the time grid as effectively as possible.

12. The NMR apparatus according to claim 11, **characterized in that** at least one pre-controller (21'; 21") is provided for the voltage supply of the digital voltage source (13).

13. The NMR apparatus according to any one of the preceding claims, **characterized in that** the current source is designed such that the electric current flowing through the NMR coil (11) can be varied within the range of from -20 A to +20 A, in particular within the range of from -1 A to +1 A.

14. The NMR apparatus according to any one of the preceding claims, **characterized in that** the NMR coil (11) is designed as a coil for shimming the NMR apparatus (10) and/or for homogenizing the NMR magnetic field generated by the NMR magnet system or for varying the NMR magnetic field, in particular by means of a flux pump.

## Revendications

1. Appareil RMN (10), avec un système magnétique RMN permettant de générer un champ magnétique RMN et comprenant au moins une bobine de RMN (11) permettant de modifier le champ magnétique RMN, et avec une source de courant stable conçue pour alimenter la bobine de RMN (11) en courant électrique et comprenant un régulateur de courant linéaire (12) connecté électriquement à une première extrémité de la bobine de RMN (11), la source de courant comprenant une source de tension numérique (13) connectée électriquement à une deuxième extrémité de la bobine de RMN (11), de sorte que la bobine de RMN (11) est connectée en tant que consommateur électrique entre le régulateur de courant linéaire (12) et la source de tension numérique (13), le régulateur de courant linéaire (12) étant connecté à la source de tension numérique (13) par l'intermédiaire d'une ligne de régulation (14) afin de réguler la tension électrique, la source de courant étant à faible bruit et la source de tension numérique (13) faisant appel à une technique de commutation, et le régulateur de courant linéaire (12) étant conçu pour réguler la source de tension numérique (13) de telle manière que la tension numérique se situe, côté régulateur de courant linéaire (12), dans une plage de fonctionnement présélectionnée, de sorte qu'une puissance électrique la plus faible possible est consommée dans le régulateur de courant linéaire (12),
**caractérisé en ce que**
le régulateur de courant linéaire (12) comprend un amplificateur électrique (19) permettant d'alimenter en courant la bobine de RMN (11).

2. Appareil RMN selon la revendication 1, **caractérisé en ce que** la source de tension numérique (13) peut être exploitée de manière pulsée.

3. Appareil RMN selon la revendication 2, **caractérisé en ce que** la fréquence d'impulsion de la source de tension numérique (13) se situe dans une plage comprise entre 10 kHz et 1 GHz, de manière préférée comprise entre 30 kHz et 200 kHz.

4. Appareil RMN selon la revendication 2 ou 3, **caractérisé en ce que** la source de tension numérique (13) peut être exploitée en modulation de largeur d'impulsion.

5. Appareil RMN selon la revendication 2 ou 3, **caractérisé en ce que** la source de tension numérique (13) présente un filtre (15) avec au moins un élément inductif, en particulier une ou plusieurs bobine(s) (15'), et avec un ou plusieurs élément(s) capacitif(s), en particulier des condensateurs (15"), connecté(s) en parallèle à la terre, le filtre (15) étant conçu pour lisser la tension de la source de tension numérique (13).

6. Appareil RMN selon l'une quelconque des revendications précédentes, **caractérisé en ce que** la source de tension numérique (13) est conçue pour fournir à la fois des valeurs de tension négatives et positives.

7. Appareil RMN selon l'une quelconque des revendications précédentes, **caractérisé en ce que** le régulateur de courant linéaire (12) comprend une résistance shunt (16) et un convertisseur analogique-numérique (17) enjambant celle-ci afin de mesurer le courant circulant à travers la bobine de RMN (11).

8. Appareil RMN selon la revendication 7, **caractérisé en ce que** le convertisseur analogique-numérique (17) est relié à une unité de régulation numérique (18).

9. Appareil RMN selon la revendication 8, **caractérisé en ce que** l'unité de régulation numérique (18) est reliée à l'amplificateur électrique (19) par l'intermédiaire d'un convertisseur analogique-numérique (20) et, de manière préférée, à la source de tension numérique (13) par l'intermédiaire de la ligne de régulation (14).

10. Appareil RMN selon l'une quelconque des revendications précédentes, **caractérisé en ce que** la commande de la source de tension numérique (13) intervient selon une trame temporelle définie, de sorte que plusieurs sources de courant utilisées simultanément n'interfèrent pas les unes avec les autres.

11. Appareil RMN selon la revendication 10 et l'une quelconque des revendications 7 ou 8, **caractérisé en ce qu'**un diviseur entier d'un intervalle de mesure du convertisseur analogique-numérique (17) est sélectionné comme trame temporelle, ou **en ce que** la trame temporelle est sélectionnée de sorte qu'un élément filtrant numérique supprime de la meilleure manière possible la fréquence de la trame temporelle.

12. Appareil RMN selon la revendication 11, **caractérisé en ce qu'**au moins un pré-régulateur (21'; 21") est prévu pour l'alimentation en tension de la source de tension numérique (13).

13. Appareil RMN selon l'une quelconque des revendications précédentes, **caractérisé en ce que** la source de courant est conçue de sorte que le courant électrique circulant dans la bobine de RMN (11) peut varier dans la plage comprise entre -20A et +20A, en particulier dans la plage comprise entre -1A et +1A.

14. Appareil RMN selon l'une quelconque des revendications précédentes, **caractérisé en ce que** la bobine de RMN (11) est conçue comme une bobine permettant de corriger l'appareil RMN (10) et/ou permettant d'homogénéiser le champ magnétique RMN généré par le système magnétique RMN ou permettant de faire varier le champ magnétique RMN, en particulier au moyen d'un pompage de flux.
